# EUROPEAN PATENT SPECIFICATION

(11) **EP 3 151 429 B1**
(45) Date of publication and mention of the grant of the patent: **18.09.2019**
(21) Application number: 15465542.7
(22) Date of filing: 29.09.2015
(51) Int. Cl.: H03K 17/082, H02M 1/32, H02H 7/08, H03K 17/16, H02K 11/26

(54) **ELECTRICAL CIRCUIT FOR DISCHARGING AN INDUCTIVE LOAD**
ELEKTRISCHE SCHALTUNG ZUM ENTLADEN EINER INDUKTIVEN LAST
CIRCUIT ÉLECTRIQUE POUR DÉCHARGER UNE CHARGE INDUCTIVE

(43) Date of publication of application: 05.04.2017
(73) Proprietor: Continental Automotive GmbH, 30165 Hannover (DE)
(72) Inventor: Tincu, Tiberiu, 550399 Sibiu (RO)

(56) References cited:
- EP-A1- 1 962 412
- WO-A1-2004/008601
- US-A1- 2011 013 328
- US-A1- 2013 207 712

## Description

Inductive loads such as motors, coils or solenoids are often controlled by switches arranged in a bridge circuit. If an inductive load must be stopped after an active phase, the energy accumulated in the active phase must be discharged via the bridge circuit. According to the state of the art, discharging can be achieved by a part of the bridge circuit kept in an active state or by electronic switches such as field effect transistors (FETs) that comprise reverse diodes.

Such an electrical circuit is known from US 2013/207712 A1.

It is an object of the present invention to provide an electrical circuit for controlling a bridge circuit for driving an inductive load that improves the safety and effectiveness of such a bridge circuit upon stopping the inductive load after an active phase. It is a further object of the present invention to provide a method for operating such an electrical circuit for controlling a bridge circuit.

The object is achieved by an electrical circuit according to claim 1 and by a method for operating an electrical circuit according to claim 5.

Preferred embodiments of the invention are given in the dependent claims.

According to the invention, an electrical circuit adapted to control a bridge circuit for driving an inductive load comprises a voltage pulse detector adapted to detect a voltage pulse on the supply voltage supplying the bridge circuit, at least one high-side control output adapted to control a high-side switch of the bridge circuit connecting the inductive load with the supply voltage, at least one low-side control output adapted to control a low-side switch of the bridge circuit connecting the inductive load with ground, an internal control logic measuring the supply voltage, evaluating the output of the voltage pulse detector and controlling the high- and low-side control outputs and one validation gate per low-side control output.

The internal control logic controls the at least one validation gate to block the connection from the voltage pulse detector output to the respective low-side control output in normal function status. In case of an overvoltage of the supply voltage or a failure in the electrical circuit or a failure in an external control logic that controls the electrical circuit, the internal control logic controls the at least one validation gate to allow the connection from the voltage pulse detector output to the respective low-side control output.

When the inductive load is stopped after an active phase, the energy stored in the inductive load must be stored back via the bridge circuit. The energy may be stored back via parts of the bridge circuit kept in an activated state, such as a high-side switch or a low-side switch kept in a closed state. In an embodiment where high- and/or low-side switches are formed as FETs comprising reverse diodes, the accumulated energy may also be stored back via reverse diodes of opened high- and/or low-side switches.

The energy is stored back by a current flowing into the power supply providing the supply voltage to the bridge circuit and, thereby, the inductive load in its active phase. This current causes a transient overvoltage or a voltage pulse on the supply voltage line which is detected by the voltage pulse detector.

According to the invention, by means of the at least one validation gate the at least one low-side switch of the bridge circuit is closed in case of such a voltage pulse under the condition that the validation gate is controlled by the internal control logic to connect through the output of the voltage pulse detector to the low-side control output of the electrical circuit. Thereby, the accumulated energy or current flows via the at least one closed low-side switch towards ground.

As an advantage, protective measures to protect the power supply from voltage pulses can be reduced or eliminated. As an example, filtering capacitors connected to the supply voltage source can be reduced in their capacitance and thus in their volume and footprint as well. Further, electromagnetic interferences that inevitably occur along power supply lines transferring a voltage pulse are reduced, thereby reducing the need for protection measures against such electromagnetic interferences.

As a further advantage, the accumulated energy is discharged along closed low-side switches even in case of a failure of the external control logic, in case of a failure of the internal control logic of the electrical circuit itself or in case of an unexpected stopping of the inductive load, as at least one low-side switch can be controlled independently from the external and internal control logic to close in case of a voltage pulse. Thereby, the power dissipation is reduced and the impact of a failure on the safety of the inductive load is reduced.

In an embodiment of the invention, the voltage pulse detector comprises a filter circuit. The filter circuit may be formed as a low-pass filter. The filter circuit may also be formed as a band-pass filter. To those skilled in the art, design methods for designing low-pass filters or band-pass filters according to a desired filter characteristics, for example according to a desired amplitude and phase gain, are well known.

In this embodiment, the filter circuit is connected with the supply voltage. In case of a voltage pulse on the supply voltage, this voltage pulse is smoothened and/or dampened and/or delayed at the output of the filter circuit. Thereby, such a voltage pulse can easily be detected by a simple comparator comparing the output of the filter circuit with the unfiltered course of the supply voltage.

Thus a voltage pulse detector is particularly easy to implement. Further, it is particularly easy to adjust a voltage pulse detector to a specific inductive load and/or to the power supply supplying such a specific inductive load. For example, filter parameters such as gain and/or filter order and/or cut-off frequencies may be chosen such that voltage pulses caused by stopping the inductive load are detected by the voltage pulse detector, whereas voltage pulses caused by electromagnetic disturbances interfering the supply voltage are not detected.

It is possible to adjust filter parameters of one filter circuit by means of adjustable components such as potentiometers. It is also possible to exchange one filter circuit by another filter circuit. Thereby, other parts of the voltage pulse detector than the filter circuit can be reused in the application for different inductive loads. For example, the comparator may be part of an application specific integrated circuit (ASIC) also comprising further part of the electrical circuit, whereas the filtering circuit may be formed as an independent external circuit.

In an embodiment of the invention, the inductive load is a motor. Braking motors in an unexpected or failsafe state while avoiding a voltage pulse on the supply voltage and/or avoiding excessive power dissipation in the bridge circuit is of particular importance for various safety-critical systems, such as motors controlling automotive applications.

In an embodiment of the invention, the bridge circuit is formed by a left and a right high-side switch connecting a left and a right contact of an inductive load with the supply voltage and by a left and a right low-side switch connecting the left and the right contact of an inductive load with ground. Such bridges are known as H-bridges to those skilled in the art. H-bridges are a particularly efficient and easy means to control a motor. They allow two different active states corresponding to opposing directions of movement of the motor, an inactive or high impedance state also denoted as High-Z state wherein the motor is decoupled from the power supply. H-bridges further allow braking of the motor by either closing both high-side switches or closing both low-side switches.

According to an embodiment of the invention, a method for operating the electrical circuit adapted to control a bridge circuit for driving an inductive load comprises the steps of
- deciding whether the supply voltage is out of an operating range,
- deciding whether the control logic is active or inactive,
- controlling the high and low side control outputs according to a predetermined brake control scheme if the control logic is active,
- controlling the at least one validation gate to connect through if the control logic is inactive and the supply voltage is within the operating range and
- deciding whether a voltage pulse persists on the supply voltage.

If the voltage pulse detector is not working properly or cannot be relied upon due to an interruption of the power supply, or if the supply voltage is out of an operating range to reliably control the at least one validation gate, this method prevents the electrical circuit to control the bridge circuit by means of the at least one validation gate.

The method according to this embodiment also blocks the validation gates if the internal control logic is active, i.e. working properly. In this case, an error and/or a voltage pulse is handled by the internal control logic that brakes the inductive load according to the previous status of the inductive load and according to a predetermined, e.g. programmed into the internal control logic, brake strategy.

If the internal control logic is inactive, i.e. not working properly, and if the supply voltage is within its operating range, a brake is initiated depending on the output of the voltage pulse detector. For initiating the brake, the validation gates are controlled to transfer the output of the voltage pulse detector to the at least one low-side control output. The output of the voltage pulse detector is activated if the voltage pulse, e.g. the difference voltage between the unfiltered supply voltage and the output of a filter circuit, exceeds a predetermined higher voltage pulse detection threshold.

Thereby, the at least one low-side switch of the bridge circuit is closed, effecting a braking of the inductive load. The brake will last as long as the voltage pulse exceeds a predetermined lower voltage pulse detection threshold that is lower than the higher voltage pulse detection threshold.

If the voltage pulse falls below said lower voltage pulse detection threshold, the output of the voltage pulse detector is deactivated and the brake process is finished. By the difference between the higher and the lower voltage pulse detection threshold, a hysteresis can be ensured.

If the brake duration was not sufficient to discharge the accumulated energy in the inductive load, a subsequent voltage pulse exceeding the higher voltage pulse detection threshold will initiate a subsequent brake. Subsequent brakes can be initiated repeatedly until the voltage pulse caused by residual, i.e. not yet discharged, accumulated energy remains below the higher voltage pulse entry threshold.

By the method according to this embodiment, accumulated energy of an inductive load is discharged avoiding excessive voltage pulses and/or energy dissipation in the bridge circuit in conditions of unexpected of failsafe states, such as in a condition of a failure of the internal logic or in a condition of a failure of the external logic controlling the electrical circuit, whereas under normal operational conditions a pre-determined brake strategy including a controlled energy discharge is controlled by the internal control logic.

The present invention will become more fully understood from the detailed description given herein below and the accompanying drawings which are given by way of illustration only, and thus, are not limitative of the present invention, and wherein:
- Figure 1: is a schematic circuit diagram of an electrical circuit controlling a bridge circuit and
- Figure 2: is a flow chart of a method for operating such an electrical circuit.

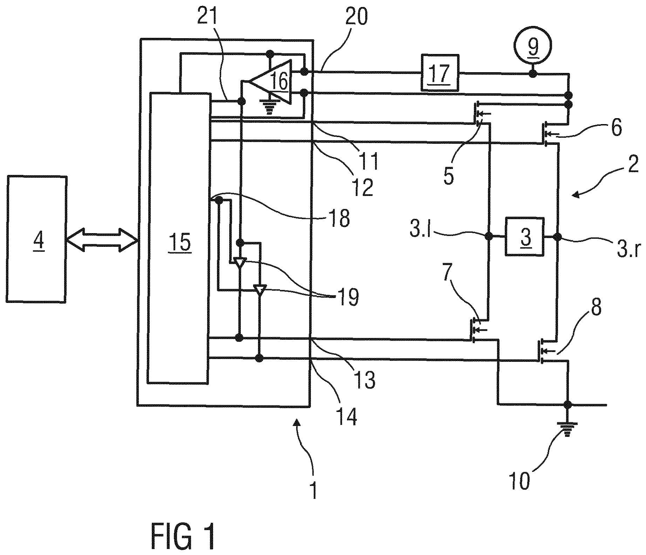

Figure 1 shows an electrical circuit 1 that controls a bridge circuit 2 driving an inductive load 3 formed as a motor 3. The electrical circuit 1, also denoted as bridge pre-driver 1, is controlled by an external control logic 4.

The motor 3 is contacted at a left contact 3.1 and at a right contact 3.r. The bridge circuit 2 is formed as an H-bridge comprising a left high-side switch 5 connecting the left contact 3.1 with a supply voltage 9, a right high-side switch 6 connecting the right contact 3.r with the supply voltage 9, a left low-side switch 7 connecting the left contact 3.1 with ground 10 and a right low-side switch 8 connecting the right contact 3.r with ground 10.

The left and right high-side switches 5, 6 are controlled by a left and a right high-side control output 11, 12 of the bridge pre-driver 1, respectively. The left and right low-side switches 7, 8 are controlled by a left and a right low-side control output 13, 14 of the bridge pre-driver 1, respectively. All control outputs 11 to 14 are controlled by an internal control logic 15.

A filter circuit 17 filters the supply voltage 9 and provides at its output a bridge pre-drive supply voltage 20 to the bridge pre-driver 1. The bridge pre-driver 1 comprises a comparator 16 comparing the supply voltage 9 with the bridge pre-drive supply voltage 20. The output of the comparator 16 is fed to the internal control logic 15 as a pulse detector output line 21. Also, the supply voltage 9 is fed to the internal control logic 15 in order to detect short-circuit on high-side switches 5,6. Further, the bridge pre-driver supply voltage 20 is fed to the internal control logic 15 for supply and in order to detect undervoltage or overvoltage conditions.

The internal control logic 15 further controls via a validation status line 18 validation gates 19 each connecting the output of the comparator 16 with one of the low-side control outputs 13, 14. The validation gates 19 connect through the output of the comparator 16 to the low-side control outputs 13, 14 if the validation status line 18 is active, thereby indicating an invalid status of the bridge pre-driver 1.

Upon normal operation of the motor 3, depending on the direction of the motor 3, either both the left high-side switch 5 and the right low-side switch 8 or both the right high-side switch 6 and the left low-side switch 7 are closed, i.e. in ON-state, while the other switches are open, i.e. in OFF-state, respectively. Braking of the motor 3 after an active phase by request of the external control logic 4 can be achieved by closing both low-side switches 7, 8 and opening both high-side switches 5, 6. Alternatively, braking can be achieved by closing both high-side switches 5, 6 and opening both low-side switches 7, 8.

It is also possible that the H-bridge 2 enters a high impedance state, also denoted as High-Z state, wherein all switches 5 to 8 are open. Such a High-Z state may be entered upon failure of the external control logic 4, upon failure of the internal control logic 15 or in an unexpectedly created safety state.

Upon braking of the motor 3 after an active phase, the energy accumulated in the motor 3 must be discharged. Those skilled in the art will appreciate, that the energy accumulated in other types of inductive loads 3, such as the energy accumulated in an activated solenoid, must be discharged upon deactivation in the same manner as for the motor 3 even if a bridge circuit controlling such an inductive load 3 may differ from the H-bridge according to the embodiment described by Figure 1.

The switches 5 to 8 may be formed as a field effect transistor (FET) with a parallel reverse diode. Then, the accumulated energy of the motor 3 is stored back to the supply voltage 9 via the reverse diode. The accumulated energy may also be stored back to the supply voltage 9 by closing at least one of the switches 5 to 8.

The discharge of the accumulated energy in the motor 3 results in a transient voltage pulse on the supply voltage 9. According to the state of the art, such a voltage pulse is limited by capacitors connected with the supply voltage 9.

A voltage pulse on the supply voltage 9 may be transferred delayed and/or smoothened by the filter circuit 17 to the bridge pre-driver 1. As an example, the filter circuit 17 may comprise at least one resistor and at least one capacitor and/or at least one inductance that form a low-pass filter. Thereby, upon a voltage pulse on the supply voltage 9, a difference voltage is caused between one input of the comparator 16 connected with the bridge pre-driver supply voltage 20 at the output of the filter circuit 17 and the other input of the comparator 16 connected with the supply voltage 9. To those skilled in the art, methods are known to design and implement a filter circuit 17 such that voltage pulses of a predetermined shape and amplitude result in a predetermined difference voltage between the inputs of the comparator 16.

According to a method described later on, the internal control logic 15 decides whether to activate the validation status line 18. If the validation status line 18 is activated, thus indicating an invalid status of the bridge pre-driver 1, the validation gates 19 connect through the output of the comparator 16 to the low-side control outputs 13, 14. The validation status line 18 may be configured failsafe such that it is activated upon failure of the internal control logic 15. Those skilled in the art know how to configure a failsafe line, for example by means of a watchdog block triggered by the internal control logic 15.

If the comparator 16 determines a voltage pulse on the supply voltage 9, the low-side switches 7, 8 are closed. Thereby, both contacts 3.1, 3.r of the motor 3 are shortened and connected with ground 10 so that the accumulated energy can be discharged.

The low-side switches 7, 8 are closed as long as the comparator 16 detects a voltage pulse and will be opened when the voltage pulse is over. If the closing duration is insufficient for completely discharging the accumulated energy, one or more subsequent voltage pulses will result in repeatedly closing the low-side switches 7, 8 until the braking process is completed.

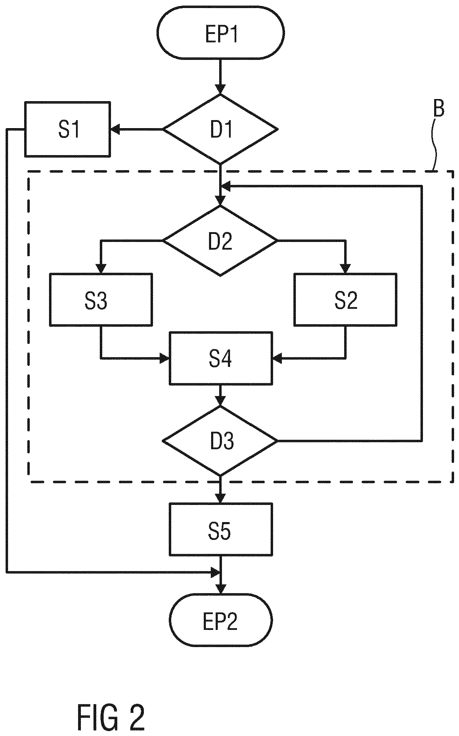

Figure 2 explains the method implemented in the internal control logic 15 for controlling the validation status line 18 in more detail.

An entry point EP1 is reached upon the condition that the comparator 16 detects a voltage pulse, i.e. a difference voltage between the bridge pre-driver supply voltage 20 at the output of the filter circuit 17 as reference and the supply voltage 9 that exceeds a predetermined voltage pulse detection threshold.

In a decision D1 it is determined whether the bridge pre-driver supply voltage 20 at the output of the filter circuit 17 is outside a predetermined functional supply voltage range. If so, in a subsequent step S1 a failure state of the bridge pre-driver is activated and an exit point EP2 is reached subsequently. The reaction of the internal control logic 15 for this case after the exit point EP2 will follow a general strategy implemented for undervoltage and overvoltage conditions.

If in the decision D1 it is determined that the bridge pre-driver supply voltage 20 at the output of the filter circuit 17 is within the predetermined functional supply voltage range, a brake process B is entered. The brake process B is designed such that the accumulated energy of the motor 3 is discharged. The brake process B comprises decisions D2 and D3 and steps S2 to S4.

In the decision D2 it is determined whether the internal control logic 15 is active. If the internal control logic 15 is active, the internal control logic 15 is informed via the pulse detector output line 21 and in a subsequent step S2 the brake strategy previously set in the internal control logic 15 is activated. If the internal control logic 15 is inactive, the validation status line 18 is activated in a subsequent step S3, thereby activating the low-side control outputs 13, 14 and closing the low-side switches 7, 8.

Subsequent to steps S2, S3 in a step S4 the supply voltage 9 is scanned for further voltage pulses by means of the comparator 16 and the filter circuit 17. The brake process is kept until the detected voltage pulse exceeds the predetermined voltage pulse detection threshold. If the voltage pulse is below this threshold, the comparator 16 deactivates the low-side control outputs 13, 14 and step S4 is ended. In a subsequent decision D3 it is determined whether a subsequent voltage pulse exceeding the predetermined voltage pulse detection threshold was detected. If so, the brake process B recursively proceeds with the decision D2.

If no subsequent voltage pulse exceeding the predetermined voltage pulse detection threshold was detected, the brake process B is left. In a subsequent step S5 the braking state is disabled, thereby deactivating the validation status line 18 or deactivating the brake strategy previously set in the internal control logic 15. Subsequently, the exit point EP2 is reached, thereby ending the method and ending the process of discharging the energy accumulated in the motor 3.

## Claims

1. Electrical circuit (1) adapted to control a bridge circuit (2) for driving an inductive load (3) and comprising
- a voltage pulse detector (16, 17) adapted to detect a voltage pulse on the supply voltage (9) supplying the bridge circuit (2),
- at least one high-side control output (11, 12) adapted to control a high-side switch (5, 6) of the bridge circuit (2) connecting the inductive load (3) with the supply voltage (9),
- at least one low-side control output (13, 14) adapted to control a low-side switch (7, 8) of the bridge circuit (2) connecting the inductive load (3) with ground (10),
- an internal control logic (15) configured to measure the supply voltage (9), evaluate the output of the voltage pulse detector (16, 17) and control the high- and low-side control outputs (11 to 14) and
- one validation gate (19) per low-side control output (13, 14), **characterized in that**
the internal control logic (15) is configured to control the at least one validation gate (19) to connect through when the supply voltage (9) exceeds a bridge pre-driver supply voltage (20) supplying the electrical circuit (1) by a pre-determined voltage pulse detection threshold, thereby connecting the respective low-side control output (13, 14) with the output of the voltage pulse detector (16, 17).

2. Electrical circuit (1) according to claim 1, wherein the voltage pulse detector (16, 17) comprises a filter circuit (17).

3. Electrical circuit (1) according to one of the previous claims, wherein the bridge circuit (2) is formed by a left and a right high-side switch (5, 6) connecting a left and a right contact (3.l, 3.r) of the inductive load (3) with the supply voltage (9) and by a left and a right low-side switch (7, 8) connecting the left and the right contact (3.1, 3.r) of the inductive load (3) with ground (10).

4. Electrical circuit (1) according to one of the previous claims, wherein the inductive load (3) is a motor (3).

5. Method for operating an electrical circuit (1) according to the previous claim comprising the steps of
- deciding whether the bridge pre-driver supply voltage (20) supplying the electrical circuit (1) is out of an operating range,
- deciding whether the internal control logic (15) is active or inactive,
- controlling the high and low-side control outputs (11 to 14) according to a predetermined brake control scheme if the internal control logic (15) is active and the bridge pre-driver supply voltage (20) is within the operating range,
- controlling the at least one validation gate (19) to connect through if the internal control logic (15) is inactive and
- deciding whether a voltage pulse persists on the supply voltage (9).

## Patentansprüche

1. Elektrische Schaltung (1) eingerichtet zum Steuern einer Brückenschaltung (2) zum Betreiben einer induktiven Last (3) und umfassend
- einen Spannungsimpulsdetektor (16, 17), der eingerichtet ist, einen Spannungsimpuls auf der Versorgungsspannung (9) zu detektieren, die die Brückenschaltung (2) versorgt,
- mindestens einen High-Side-Steuerausgang (11, 12), der zum Steuern eines High-Side-Schalters (5, 6) der Brückenschaltung (2) eingerichtet ist, der die induktive Last (3) mit der Versorgungsspannung (9) verbindet,
- mindestens einen Low-Side-Steuerausgang (13, 14), der zum Steuern eines Low-Side-Schalters (7, 8) der Brückenschaltung (2) eingerichtet ist, der die induktive Last (3) mit Masse (10) verbindet,
- eine interne Steuerlogik (15), die zum Messen der Versorgungsspannung (9), zum Auswerten des Ausgangs des Spannungsimpulsdetektors (16, 17) und zum Steuern der High- und Low-Side-Steuerausgänge (11 bis 14) ausgelegt ist, und
- ein Validierungsgatter (19) pro Low-Side-Steuerausgang (13, 14), **dadurch gekennzeichnet, dass**
die interne Steuerlogik (15) zum Steuern des mindestens einen Validierungsgatters (19) zum Durchschalten ausgelegt ist, wenn die Versorgungsspannung (9) eine Brücken-Vortreiber-Versorgungsspannung (20) überschreitet, die die elektrische Schaltung (1) mit einem vorbestimmten Spannungsimpuls-Detektionsschwellenwert versorgt, wodurch der jeweilige Low-Side-Steuerausgang (13, 14) mit dem Ausgang des Spannungsimpulsgebers (16, 17) verbunden wird.

2. Elektrische Schaltung (1) nach Anspruch 1, wobei der Spannungsimpulsdetektor (16, 17) eine Filterschaltung (17) umfasst.

3. Elektrische Schaltung (1) nach einem der vorhergehenden Ansprüche, wobei die Brückenschaltung (2) durch einen linken und einen rechten High-Side-Schalter (5, 6) gebildet ist, die einen linken und einen rechten Kontakt (3.l, 3.r) der induktiven Last (3) mit der Versorgungsspannung (9) verbinden, und durch einen linken und einen rechten Low-Side-Schalter (7, 8), die den linken und den rechten Kontakt (3.l, 3.r) der induktiven Last (3) mit Masse (10) verbinden.

4. Elektrische Schaltung (1) nach einem der vorhergehenden Ansprüche, wobei die induktive Last (3) ein Motor (3) ist.

5. Verfahren zum Betreiben einer elektrischen Schaltung (1) nach dem vorhergehenden Anspruch, umfassend die Schritte:
- Entscheiden, ob die die elektrische Schaltung (1) versorgende Brücken-Vortreiber-Versorgungsspannung (20) außerhalb eines Betriebsbereichs liegt,
- Entscheiden, ob die interne Steuerlogik (15) aktiv oder inaktiv ist,
- Steuern der High- und Low-Side Steuerausgänge (11 bis 14) gemäß einem vorbestimmten Bremssteuerschema, wenn die interne Steuerlogik (15) aktiv ist und die Brücken-Vortreiber-Versorgungsspannung (20) innerhalb des Betriebsbereichs liegt,
- Steuern des mindestens einen Validierungsgatters (19) zum Durchschalten, wenn die interne Steuerlogik (15) inaktiv ist und
- Entscheiden, ob ein Spannungsimpuls an der Versorgungsspannung (9) anliegt.

## Revendications

1. Circuit électrique (1) capable de commander un circuit de pont (2) pour attaquer une charge inductive (3) et comprenant
- un détecteur d'impulsion de tension (16, 17) capable de détecter une impulsion de tension sur la tension d'alimentation (9) qui alimente le circuit de pont (2),
- au moins une sortie de commande de côté haut (11, 12) capable de commander un commutateur de côté haut (5, 6) du circuit de pont (2) reliant la charge inductive (3) à la tension d'alimentation (9),
- au moins une sortie de commande de côté bas (13, 14) capable de commander un commutateur de côté bas (7, 8) du circuit de pont (2) reliant la charge inductive (3) à la masse (10),
- une logique de commande interne (15) configurée pour mesurer la tension d'alimentation (9), évaluer la sortie du détecteur d'impulsion de tension (16, 17) et commander les sorties de commande de côté haut et de côté bas (11 à 14) et
- une porte de validation (19) par sortie de commande de côté bas (13, 14), **caractérisée en ce que** la logique de commande interne (15) est configurée pour commander ladite au moins une porte de validation (19) pour qu'elle se mette en connexion lorsque la tension d'alimentation (9) dépasse une tension d'alimentation de circuit de pré-attaque de pont (20) alimentant le circuit électrique (1) d'un seuil de détection d'impulsion de tension prédéterminé, ce qui met en connexion la sortie de commande de côté bas (13, 14) respective avec la sortie du détecteur d'impulsion de tension (16, 17).

2. Circuit électrique (1) selon la revendication 1, dans lequel le détecteur d'impulsion de tension (16, 17) comprend un circuit de filtrage (17).

3. Circuit électrique (1) selon l'une quelconque des revendications précédentes, dans lequel le circuit de pont (2) est formé par des commutateurs de côté haut gauche et droit (5, 6) reliant des contacts gauche et droit (3.l, 3.r) de la charge inductive (3) à la tension d'alimentation (9) et par des commutateurs de côté bas gauche et droit (7, 8) reliant les contacts gauche et droit (3.l, 3.r) de la charge inductive (3) à la masse (10).

4. Circuit électrique (1) selon l'une quelconque des revendications précédentes, dans lequel la charge inductive (3) est un moteur (3).

5. Procédé d'utilisation d'un circuit électrique (1) selon la revendication précédente, comprenant les étapes consistant à
- déterminer si la tension d'alimentation de circuit de pré-attaque de pont (20) alimentant le circuit électrique (1) se trouve en dehors d'une plage de fonctionnement,
- déterminer si la logique de commande interne (15) est active ou inactive,
- commander les sorties de commande de côté haut et de côté bas (11 à 14) selon un schéma de commande de freinage prédéterminé si la logique de commande interne (15) est active et que la tension d'alimentation de circuit de pré-attaque de pont (20) se trouve dans la plage de fonctionnement,
- commander ladite au moins une porte de validation (19) pour qu'elle se mette en connexion si la logique de commande interne (15) est inactive et
- déterminer si une impulsion de tension persiste sur la tension d'alimentation (9).
